(19) Europäisches Patentamt / European Patent Office / Office européen des brevets

(11) **EP 4 760 298 A1**

(12) **EUROPEAN PATENT APPLICATION**
published in accordance with Art. 153(4) EPC

(43) Date of publication:
17.06.2026 Bulletin 2026/25

(21) Application number: 24913809.0

(22) Date of filing: 13.12.2024

(51) International Patent Classification (IPC):
*G01R 31/382* (2019.01)    *G01R 31/392* (2019.01)
*G01R 31/396* (2019.01)    *G01R 19/165* (2006.01)
*B60L 58/10* (2019.01)      *H01M 10/052* (2010.01)

(52) Cooperative Patent Classification (CPC):
**B60L 58/10; G01R 19/165; G01R 31/382;**
**G01R 31/392; G01R 31/396; H01M 10/052;**
Y02E 60/10

(86) International application number:
**PCT/KR2024/096979**

(87) International publication number:
**WO 2025/144005 (03.07.2025 Gazette 2025/27)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: 26.12.2023 KR 20230191795

(71) Applicant: **LG Energy Solution, Ltd.**
**Seoul 07335 (KR)**

(72) Inventor: **PARK, Se-Young**
**Daejeon 34122 (KR)**

(74) Representative: **Plasseraud IP**
**104 Rue de Richelieu**
**CS92104**
**75080 Paris Cedex 02 (FR)**

(54) **APPARATUS FOR MANAGING BATTERY**

(57)    An apparatus for managing a battery may include a measurement module configured to measure state information of the battery, a first diagnosis module configured to diagnose whether the battery is abnormal by comparing the state information measured by the measurement module with a first diagnosis criterion, and a second diagnosis module configured to diagnose whether the battery is abnormal based on a change amount of the state information measured by the measurement module.

FIG. 1

**Description**

TECHNICAL FIELD

The present application claims priority to Korean Patent Application No. 10-2023-0191795 filed on December 26, 2023 in the Republic of Korea, the disclosures of which are incorporated herein by reference.
The present disclosure relates to a battery management technology, and more specifically, to a technology that may more accurately diagnose whether a battery is abnormal.

BACKGROUND ART

Currently commercialized secondary batteries include nickel-cadmium batteries, nickel-hydrogen batteries, nickel-zinc batteries, lithium secondary batteries, and the like. Among them, the lithium secondary batteries are spotlighted because they ensure free charging and discharging due to substantially no memory effect compared to nickel-based secondary batteries, as well as very low self-discharge rate and high energy density.
Recently, batteries (secondary batteries) have been widely used for driving or energy storage in vehicles such as electric two-wheeled vehicles and electric vehicles medium and large-sized devices such as energy storage systems (ESS). For this reason, the interest in batteries is further increased, and related research and development are being made more actively. Moreover, commercialization and research are being actively conducted on exchangeable public battery packs for electric two-wheeled vehicles and electric vehicles.
The lithium secondary battery mainly uses lithium-based oxide and carbon material as positive electrode active material and negative electrode active material, respectively. Also, the lithium secondary battery includes an electrode assembly in which a positive electrode plate and a negative electrode plate respectively coated with a positive electrode active material and a negative electrode active material are arranged with a separator interposed therebetween, and an exterior material, namely a battery case, for hermetically receiving the electrode assembly together with electrolyte.
A plurality of secondary batteries may be electrically connected to each other and stored together inside a module case (module housing) or a pack case (pack housing) to constitute a battery module or a battery pack. At this time, each secondary battery included in the battery module or the battery pack may be referred to as a battery cell.
To ensure stable performance for batteries in the form of battery cells, battery modules and battery packs, and to protect devices equipped with these batteries and users who use these batteries, it is very important to diagnose the state of the battery and take appropriate measures. As a representative technology for this, a battery pack or ESS may include a control device such as a BMS (Battery Management System) to diagnose the battery and perform related actions.
In particular, when an abnormal situation occurs while the battery is in use, it is very important to quickly and accurately diagnose the abnormal situation. If the abnormal situation, such as high voltage or low voltage, is not properly diagnosed, battery failure or damage may occur, and in severe cases, the battery may ignite or explode, resulting in serious damage to life or property.
In the past, various technologies have been developed or used to diagnose abnormal situations in batteries for high voltage or low voltage, but it is difficult to say that sufficient technology has been secured so far. In particular, in unusual situations where charging or discharging occurs very rapidly, the technology to quickly diagnose the corresponding situation and quickly take appropriate action may be considered insufficient.

DISCLOSURE

Technical Problem

The present disclosure is designed to solve the problems of the related art, and therefore the present disclosure is directed to providing an apparatus for managing a battery that may more quickly and accurately diagnose abnormal situations of a battery, and application devices such as a battery pack that includes the apparatus.
These and other objects and advantages of the present disclosure may be understood from the following detailed description and will become more fully apparent from the embodiments of the present disclosure. Also, it will be easily understood that the objects and advantages of the present disclosure may be realized by the means shown in the appended claims and combinations thereof.

Technical Solution

In one aspect of the present disclosure, there is provided an apparatus for managing a battery. The apparatus may include a measurement module configured to measure state information of the battery, a first diagnosis module configured to diagnose whether the battery is abnormal by comparing the state information measured by the measurement module with a first diagnosis criterion, and a second diagnosis module configured to diagnose whether the battery is abnormal based on a change amount of the state information measured by the measurement module.
Here, the state information may include a voltage value, and the first diagnosis module and the second diagnosis module may be configured to diagnose whether the battery has low voltage or overvoltage.
In addition, the first diagnosis criterion may be configured in multi-stage form, and the first diagnosis module may be configured to classify an abnormal state of the battery into a plurality of diagnosis stages.

In addition, the first diagnosis module may be configured to diagnose whether the battery is abnormal by considering a time duration of the state information measured by the measurement module together.

In addition, the second diagnosis module may be configured to enable abnormality diagnosis in a situation where abnormality is not diagnosed by the first diagnosis module.

In addition, the measurement module may measure the state information periodically, and the second diagnosis module may be configured to calculate the change amount of the state information by using currently measured state information and state information measured in a previous period.

In addition, the second diagnosis module may be configured to diagnose whether the battery is abnormal by comparing the change amount of the state information with a second diagnosis criterion.

In addition, the second diagnosis module may be configured to diagnose whether the battery is abnormal by comparing a number of times the change amount of the state information deviates from the second diagnosis criterion with a criterion number.

In addition, the criterion number may have different values depending on the change amount of the state information.

In addition, the second diagnosis module may be configured to diagnose whether the battery is abnormal by changing the criterion number, when the change amount of the state information changes.

In addition, the second diagnosis module may be configured to compare the state information measured by the measurement module with a third diagnosis criterion and operate when the measured state information deviates the third diagnosis criterion.

In addition, the second diagnosis module may be configured to block a charging operation or a discharging operation of the battery when the battery is diagnosed as abnormal.

In addition, the second diagnosis module may be configured to perform an operation with priority over the first diagnosis module.

In another aspect of the present disclosure, there is also provided a battery pack, which may include the apparatus for managing the battery according to the present disclosure.

In still another aspect of the present disclosure, there is also provided a vehicle, which may include the apparatus for managing the battery according to the present disclosure.

In still another aspect of the present disclosure, there is also provided a battery providing system, which may include the apparatus for managing the battery according to the present disclosure.

Advantageous Effects

According to one aspect of the present disclosure, abnormal situations in the battery may be diagnosed more quickly and accurately.

In particular, according to an embodiment of the present disclosure, in situations where battery charging and discharging occurs abnormally rapidly, high voltage or low voltage situations may be diagnosed accurately and quickly.

Therefore, according to this aspect of the present disclosure, it is possible to provide an environment in which appropriate measures may be taken quickly in dangerous situations where the battery operates abnormally. Accordingly, the safety of the battery may be improved, and furthermore, the safety of a device or system equipped with the battery and users who use the same may be secured.

In addition, various other additional or more specific effects can be achieved by various embodiments of the present disclosure. The various effects of the present disclosure are explained in detail in each embodiment, or any effects that can be easily understood by those skilled in the art will not be described in detail.

DESCRIPTION OF DRAWINGS

The accompanying drawings illustrate one or more embodiments of the present disclosure and together with the foregoing disclosure, serve to provide further understanding of the technical features of the present disclosure, and thus, the present disclosure is not construed as being limited to the drawing.

FIG. 1 is a block diagram schematically showing a functional configuration of an apparatus for managing a battery according to an embodiment of the present disclosure.
FIG. 2 is a diagram showing an example of plurality of diagnosis stages by a first diagnosis module of the apparatus for managing a battery according to an embodiment of the present disclosure.
FIG. 3 is a diagram schematically showing an example of a low voltage diagnosis criterion for a battery by the first diagnosis module according to an embodiment of the present disclosure.
FIG. 4 is a graph showing a voltage measurement result of the battery according to an embodiment of the present disclosure.
FIG. 5 is a diagram schematically showing an example of a low voltage diagnosis criterion for the battery by a second diagnosis module according to an embodiment of the present disclosure.
FIG. 6 is a graph showing voltage measurement values of the battery according to different embodiments of the present disclosure.
FIG. 7 is a graph schematically showing the configuration for diagnosing whether the battery is abnormal by the second diagnosis module according to an embodiment of the present disclosure.
FIG. 8 is a table schematically showing a low voltage diagnosis criterion of the battery by a second diagnosis module according to another embodiment of the present disclosure.

FIG. 9 is a flowchart for schematically illustrating the operation of the apparatus for managing a battery according to an embodiment of the present disclosure.

BEST MODE

Hereinafter, embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just an example for the purpose of illustrations only, not intended to limit the scope of the disclosure, so it should be understood that other equivalents and modifications could be made thereto without departing from the scope of the disclosure.

This specification may include several embodiments. Here, any features identical or similar to those of other embodiments will not be described in detail, and any distinctive features in each embodiment may be described in detail.

Meanwhile, terms such as '... module' may be used in this specification, but this indicates a logical structural unit, and components included in the present disclosure do not necessarily indicate components that can or must be physically separated.

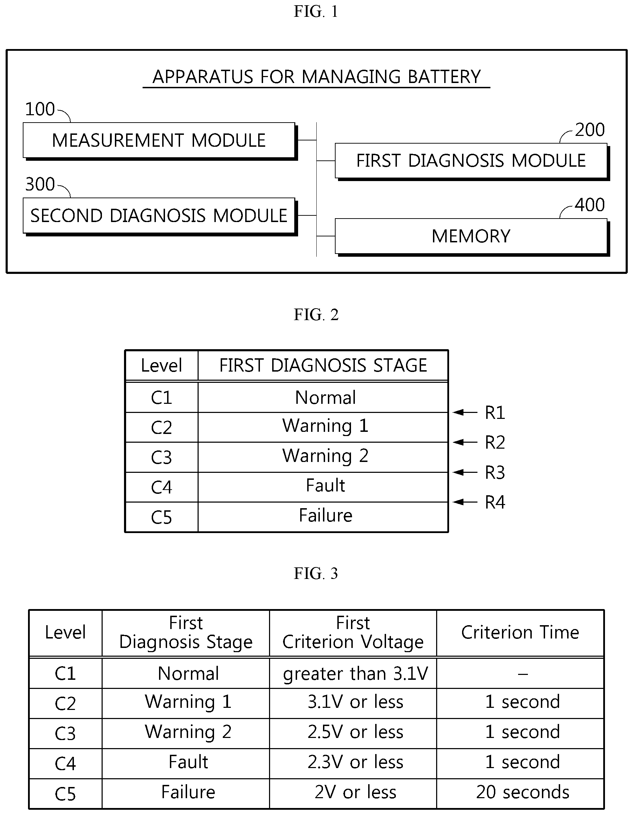

FIG. 1 is a block diagram schematically showing a functional configuration of an apparatus for managing a battery according to an embodiment of the present disclosure.

Referring to FIG. 1, the apparatus for managing a battery according to the present disclosure includes a measurement module 100, a first diagnosis module 200, and a second diagnosis module 300.

The measurement module 100 may be configured to measure state information of a battery. Here, the battery may be a concept including a battery cell representing a single secondary battery, a cell group including a plurality of such battery cells, or a battery module, a battery pack, a battery rack, etc.

The state information of the battery may include the internal state and/or external state of the battery. For example, the measurement module 100 may measure the voltage of the battery as the state of the battery. In this case, the measurement module 100 may be implemented as a voltage sensor or as having a voltage sensor. In particular, when the apparatus for managing a battery according to the present disclosure is configured to diagnose low voltage and/or overvoltage for the battery, the measurement module 100 may measure the voltage between both terminals (positive electrode terminal and negative electrode terminal) of the battery.

Alternatively, the measurement module 100 may measure information such as current, temperature, SOC (State Of Charge), internal resistance, SOH (State Of Health), etc. about the battery as the state information of the battery. For example, the apparatus for managing a battery according to the present disclosure may be configured to diagnose abnormalities in temperature (high temperature, low temperature), charging and discharging overcurrent, temperature imbalance between cells, SOC imbalance between cells, etc. for the battery. In this case, the measurement module 100 may be configured to measure or calculate at least one factor among voltage, current, temperature, SOC, internal resistance, and SOH of the battery in order to perform the corresponding diagnosis operation.

The first diagnosis module 200 may be configured to diagnose whether the battery is abnormal using the state information of the battery measured by the measurement module 100. To this end, the first diagnosis module 200 may receive the measurement value of the state information of the battery from the measurement module 100. Also, the first diagnosis module 200 may compare the received measurement value with a first diagnosis criterion.

Here, the first diagnosis criterion is a reference value for the first diagnosis module 200 to compare with the measurement value transmitted from the measurement module 100, and may be a criterion for distinguishing whether the battery is abnormal. The first diagnosis criterion may be expressed as a specific value or a specific range. For example, if the state information measured by measurement module 100 is voltage, the first diagnosis criterion may be expressed as a specific voltage value. As a more specific example, the first diagnosis criterion may be expressed as a specific voltage value, such as 3.1 V. In this case, the first diagnosis module 200 may diagnose whether the battery is abnormal using 3.1V as the criterion.

The first diagnosis criterion may be stored in advance in a specific component or calculated depending on the situation. For example, the first diagnosis criterion may be stored in the first diagnosis module 200 itself, or stored in another component out of the first diagnosis module 200. Alternatively, the first diagnosis criterion may be transmitted to the first diagnosis module 200 from another external component, such as a server located outside the apparatus for managing a battery, through a wired or wireless communication network.

The second diagnosis module 300 may be configured to diagnose whether the battery is abnormal using the state information of the battery measured by the measurement module 100. In other words, when the state information of the battery is measured by the measurement module 100, the measurement value may be transmitted to both the first diagnosis module 200 and the second diagnosis module 300, and serve as data for performing each diagnosis operation. At this time, the diagnosis operation by the first diagnosis module 200 and the diagnosis operation by the second diagnosis module 300 may be performed differently from each other. To distinguish each diagnosis operation, the diagnosis operation performed by the first diagnosis module 200 may be expressed as a first diagnosis operation, and the diagnosis operation performed by the second diagnosis module 300 may be expressed as a second diagnosis operation.

In particular, the second diagnosis module 300 may diagnose whether the battery is abnormal based on the change amount of the state information. In other words, when the state information of the battery is measured by the measurement module 100, the second diagnosis module 300 may diagnose whether the battery is abnormal, according to how much the measured state information has changed. The first diagnosis module 200 diagnoses whether the battery is abnormal by comparing the measurement value of the state information itself with the criterion value (first diagnosis criterion), while the second diagnosis module 300 may diagnose whether the battery is abnormal after deriving the change amount for the measurement value of the state information.

For example, when overvoltage or low voltage of the battery is diagnosed by the apparatus for managing a battery according to the present disclosure, the voltage value of the battery may be measured by the measurement module 100. At this time, the first diagnosis module 200 may diagnose whether the battery is abnormal by comparing the measured voltage value with the first diagnosis criterion as it is. Meanwhile, the second diagnosis module 300 may diagnose whether the battery is abnormal by deriving the change amount for the voltage value, rather than using the measured voltage value as it is.

According to this embodiment, the state of the battery may be determined more accurately. In particular, for the same measurement value, diagnosis operations may be performed in different forms, so that diagnoses for the same battery may complement each other. For example, since the diagnosis operation for low voltage is performed in multiple different ways through voltage measurement value, more accurate diagnosis may be possible in various situations. Therefore, it may be possible to respond more quickly and efficiently to abnormal states such as battery failure.

The first diagnosis module 200 and the second diagnosis module 300 may selectively include a processor, a controller, an application-specific integrated circuit (ASIC), other chipsets, logic circuits, registers, a communication modem, a data processing device or part, etc. known in the art to perform related operations or functions. Also, their operations may be implemented as software, in which case the program may be stored in an internal or external memory of the corresponding part. In this respect, the first diagnosis module 200 and the second diagnosis module 300 may be replaced with terms such as processor, controller, or chipset.

Moreover, the first diagnosis module 200 and the second diagnosis module 300 may be implemented by one component or one part. For example, the first diagnosis module 200 and the second diagnosis module 300 may be implemented by a single processor or chipset.

As a more specific example, the apparatus for managing a battery according to the present disclosure may include the measurement module 100 and a processor. At this time, the processor may include the first diagnosis module and the second diagnosis module. That is, the processor may be configured to perform the diagnosis operations of the first diagnosis module and the second diagnosis module in an integrated manner.

In particular, the first diagnosis module 200 and the second diagnosis module 300 may be implemented by a BMS (Battery Management System) included in a battery pack or ESS.

Also, the first diagnosis module 200 and/or the second diagnosis module 300 may not necessarily have to be physically integrated or located at the same location. That is, at least some functions of the first diagnosis module 200 and/or the second diagnosis module 300 may be divided and implemented by different parts or components. For example, some functions of the first diagnosis module 200 may be performed at the battery pack, such as the BMS, and other functions of the first diagnosis module 200 may be performed at the vehicle, such as ECU (Energy Control Unit) or VCU (Vehicle Control Unit).

The apparatus for managing a battery according to the present disclosure may further include a memory 400 as shown in FIG. 1.

The memory 400 may store various data or programs necessary for the first diagnosis module 200 and/or the second diagnosis module 300 to perform their functions. For example, the memory 400 may store the first diagnosis criterion. In addition, the memory 400 may store various data necessary for performing the first diagnosis operation and/or the second diagnosis operation included in this specification.

The memory 400 may be implemented in an integrated form with other components included in the apparatus for managing a battery, such as a component functioning as the first diagnosis module 200 and/or the second diagnosis module 300. For example, the memory 400 may be implemented as an internal memory provided to a processor that functions as the first diagnosis module 200 and the second diagnosis module 300.

The memory 400 has no particular restrictions on the type of storage medium as long as it can record and erase information. For example, the memory 400 may be implemented as a RAM, ROM, register, hard disk, optical recording medium, or magnetic recording medium.

Both the first diagnosis module 200 and the second diagnosis module 300 may be configured to diagnose whether the battery is in low voltage (Under Voltage) or overvoltage (Over Voltage).

In this case, the measurement module 100 may be implemented as a voltage sensor, and may measure the voltage as the state information of the battery and provide the voltage to the first diagnosis module 200 and the second diagnosis module 300. Then, the first diagnosis module 200 and the second diagnosis module 300 may perform the diagnosis operation thereof, namely the first diagnosis operation and the second diagnosis operation, using the provided voltage measurement value.

More specifically, the first diagnosis module 200 may compare the voltage measurement value with the first diagnosis criterion and determine whether the battery is abnormal according to the comparison result. If the first diagnosis criterion for measuring low voltage is 3.1V, the first diagnosis module 200 may determine whether the voltage measurement value exceeds 3.1V. If the voltage measurement value exceeds the first diagnosis criterion (3.1V), the first diagnosis module 200 may diagnose that the battery state is normal. Meanwhile, if the voltage measurement value is less than or equal to the first diagnosis criterion (3.1V), the battery state may be diagnosed as an abnormal state, namely a low voltage state.

Also, the second diagnosis module 300 may calculate the change amount of the voltage measurement value. In addition, it is possible to determine whether the battery is abnormal according to the voltage change amount calculated in this way. If the voltage change amount of the battery is not large, the second diagnosis module 300 may diagnose that the battery state is normal. Meanwhile, if the voltage change amount of the battery is equal to or larger than a certain level, the second diagnosis module 300 may diagnose the battery state as an abnormal state, such as a low voltage state.

The first diagnosis module 200 may be configured to classify the abnormal state of the battery into a plurality of diagnosis stages. This will be described in more detail with reference to FIG. 2.

FIG. 2 is a diagram showing an example of plurality of diagnosis stages by a first diagnosis module of the apparatus for managing a battery according to an embodiment of the present disclosure.

Referring to FIG. 2, the first diagnosis stage diagnosed by the first diagnosis module may be divided into five levels (Level C1 to C5). Here, Normal (Level C1) indicates the normal state for the corresponding state information of the battery, and the remaining four diagnosis stages, namely Warning 1 (Level C2), Warning 2 (Level C3), Fault (Level C4), and Failure (Level C5) ) may be regarded as indicating abnormal states for the corresponding state information of the battery. Furthermore, Warning 1, Warning 2, Fault, and Failure may be referred to or interpreted as warning, danger, fault, and failure in that order, and may indicate that more serious problems occur in that order. In other words, Failure may indicate the most serious abnormal state of the battery. For example, when the apparatus for managing a battery according to the present disclosure diagnoses the overvoltage of the battery, Failure may indicate the case where the overvoltage state of the battery is most serious. However, of course, the name or meaning of each level indicating the level of abnormal state may be modified into various other forms.

The first diagnosis module 200 may determine which diagnosis stage the battery subject to diagnosis belongs to among the plurality of diagnosis stages. For example, when determining whether the battery is in low voltage, the first diagnosis module 200 may distinguish whether the battery is in a normal state (Normal) or a low voltage state. Furthermore, if the battery is in a low voltage state, the first diagnosis module 200 may diagnose the state to be distinguished into Warning 1, Warning 2, Fault, or Failure for the low voltage level, depending on how serious it is.

In this way, for multi-stage diagnosis of the battery, the first diagnosis criterion may be configured in a multi-stage form. In particular, the first diagnosis criterion may have two or more criterion values. For example, seeing the embodiment of FIG. 2, when the battery is diagnosed in five stages, three first diagnosis criteria, such as R1, R2, R3, and R4, may be provided. Here, R1, R2, R3, and R4 may be criteria for distinguishing between Level C1 and Level C2, between Level C2 and Level C3, between Level C3 and Level C4, and between Level C4 and Level C5. At this time, each diagnosis criterion is a specific number and may be a boundary value that distinguishes each stage. As another example, each diagnosis criterion may be a specific range representing each stage.

In this way, if the diagnosis criterion has multiple criterion values in a multi-stage form, the diagnosis stages may be divided into five or more diagnosis stages. In other words, the number of diagnosis stages may be one more than the number of criterion values. For example, in the embodiment of FIG. 2, since there are four criterion values, the diagnosis stages may be divided into five diagnosis stages.

Moreover, the first diagnosis criterion may be configured to classify the abnormal state of the battery into two or more diagnosis stages. For example, in the embodiment of FIG. 2, the first diagnosis criterion may have three criterion values R2, R3, R4 to classify the abnormal state of the battery by level. In this case, the first diagnosis module 200 may diagnose the abnormal state of the battery to be distinguished into four stages (Warning 1, Warning 2, Fault, Failure).

The plurality of diagnosis stages or the first diagnosis criterion for distinguishing them as shown in FIG. 2 are information necessary for the first diagnosis module 200 to perform the first diagnosis operation, and may be stored in the first diagnosis module 200 or the memory 400.

The first diagnosis module 200 may be configured to consider the duration time of the state information together when diagnosing whether the battery is abnormal. In other words, the first diagnosis module 200 may distinguish whether the battery is abnormal or how much the battery is abnormal by considering both the state information condition and the duration time condition. This will be described in more detail with reference to FIG. 3 further.

FIG. 3 is a diagram schematically showing an example of a low voltage diagnosis criterion for a battery by the first diagnosis module 200 according to an embodiment of the present disclosure.

Referring to FIG. 3, the first diagnosis module 200 displays a first criterion voltage as the first diagnosis criterion for determining whether the battery has low voltage and thus is in an abnormal state. In particular, the first diagnosis module 200 may diagnose whether the battery is normal or abnormal in relation to the low voltage state of the battery, using 3.1V as the first criterion voltage. If the battery voltage measured by the measurement module 100 exceeds 3.1V, the first diagnosis module 200 may diagnose the battery in a normal state. Meanwhile, if the measurement voltage of the battery is 3.1V or less, the first diagnosis module 200 may diagnose that the battery is in a low voltage state and is abnormal.

At this time, the first diagnosis module 200 may perform a more specific diagnosis on the low voltage state of the battery by adding 2.5V, 2.3V, and 2V as the first criterion voltage. For example, if the battery voltage is 3.1V or less, the first diagnosis module 200 may diagnose the low voltage state of the battery as a warning (Warning 1) stage. Also, if the battery voltage is 2.5V or less, the first diagnosis module 200 may diagnose the low voltage state of the battery as a danger (Warning 2) stage. In addition, if the battery voltage is 2.3V or less, the first diagnosis module 200 may diagnose the low voltage state of the battery as a fault (Fault) stage, which is a more serious state. In particular, if the battery voltage is 2V or less, the first diagnosis module 200 may diagnose the low voltage state of the battery as a failure (Failure) stage, which is the most serious state.

Here, the first diagnosis module 200 may be configured to finally diagnose the abnormal state of the battery by considering how long each abnormal state is maintained. In particular, the first diagnosis module 200 may diagnose an abnormal state for each level if the abnormal state is maintained for a certain period of time or more. At this time, if there are a plurality of abnormal state levels of the battery, the time conditions for each abnormal state level may be the same or different.

For example, in the embodiment shown in FIG. 3, for each abnormal level of the battery (Warning 1, Warning 2, Fault, Failure), the criterion time may be set to 1 second, 1 second, 1 second, and 20 seconds. At this time, if the measurement voltage of the battery is maintained for the criterion time or more in each diagnosis stage, the abnormal state may be finally determined as the corresponding diagnosis stage. More specifically, the first diagnosis module 200 may diagnose the low voltage state of the corresponding battery as a warning (Warning 1) stage if the measurement voltage of the battery equal to or less than 3.1V is maintained for 1 second or more. In addition, the first diagnosis module 200 may diagnose the low voltage state of the corresponding battery as a danger (Warning 2) stage if the measurement voltage of the battery equal to or less than 2.5V is maintained for 1 second or more. In addition, the first diagnosis module 200 may diagnose the low voltage state of the corresponding battery as a fault (Fault) stage if the measurement voltage of the battery equal to or less than 2.3V is maintained for 1 second or more. In addition, the first diagnosis module 200 may diagnose the low voltage state of the corresponding battery as a failure (Fault) stage if the measurement voltage of the battery equal to or less than 2.0V is maintained for 10 seconds or more.

If the measured voltage value itself satisfies the first criterion voltage condition of each level but the duration time does not satisfy the criterion time condition, the first diagnosis module 200 may immediately diagnose the abnormal state as an immediately higher level. For example, if the measurement voltage value is 3.1V or less that satisfies the first criterion voltage of the C2 level but this voltage value is maintained for only 0.5 seconds, the first diagnosis module 200 may not diagnose the low voltage state of the battery as the C2 level (Warning 1) but diagnose as the C1 level (Normal), which is an immediately higher level. As another example, if the measurement voltage value is 2.5V or less that satisfies the first criterion voltage of the C3 level but the voltage value is maintained for only 0.5 seconds, the first diagnosis module 200 may not diagnose the low voltage state of the battery as the C3 level (Warning 2) but may immediately diagnose as the C2 level (Warning 1), which is an immediately higher level.

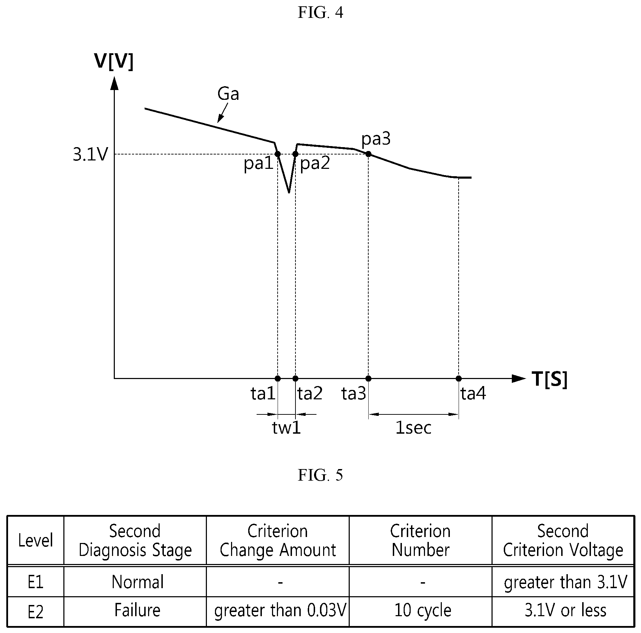

In this way, an embodiment that considers the duration time together with the state information to diagnose an abnormal state of the battery will be described in more detail with reference to FIG. 4.

FIG. 4 is a graph showing a voltage measurement result of the battery according to an embodiment of the present disclosure. In particular, FIG. 4 shows the voltage measurement result in a battery discharge situation, and may be used for low voltage diagnosis for the battery.

Referring to FIG. 4, the voltage measurement value for a specific battery is indicated as Ga. Here, the horizontal axis T represents time, and the vertical axis V represents voltage. Here, the unit of the horizontal axis may be seconds (sec), and the unit of the vertical axis may be volts (V), but they may be expressed in other units. In addition, it is assumed that a criterion voltage of 3.1V is set as the first diagnosis criterion for diagnosing an abnormal state, especially a low voltage state, for this battery. Furthermore, 3.1V may be a criterion for distinguishing between the normal (Normal) state and the abnormal state, particularly the normal state and the warning (Warning 1) state, as previously described in the embodiment of FIG. 3. In this embodiment, the case where the criterion time for diagnosis as a warning stage is 1 second will be described.

In the graph of FIG. 4, before the pa1 point, the voltage measurement value exceeds the criterion voltage (3.1V), so the first diagnosis module 200 may diagnose the corresponding battery as normal. However, seeing the graph, a value of 3.1V or less is temporarily measured between the pa1 point and the pa2 point. At this time, the first diagnosis module 200 may determine whether the time between the pa1 point and the pa2 point (ta2-ta1), namely the length of the section indicated by tw1 in FIG. 4, exceeds 1 second, which is the criterion time of the warning stage. If tw1 is less than 1 second, for the section between the pa1 point and the pa2 point, the first diagnosis module 200 may not diagnose the battery state as a warning stage in relation to low voltage of the battery, but diagnose as a normal stage.

Also, in the graph of FIG. 4, after the pa3 point, the voltage measurement value of the battery is continuously 3.1V or below. In this case, if the voltage measurement value of the battery is 3.1V or less for 1 second or more, the first diagnosis module 200 may diagnose the low voltage of the corresponding battery as an abnormal state, especially a warning stage. For example, in the graph of FIG. 4, at the ta4 time point, which is 1 second after the ta3 time point corresponding to the pa3 point, the first diagnosis module 200 may diagnose the low voltage of the battery as a warning (Warning 1) stage.

The first criterion voltage (first diagnosis criterion) and the criterion time corresponding to each diagnosis stage as described in FIGS. 3 and 4 may be stored in advance in the first diagnosis module 200 or the memory 400. Alternatively, the criterion voltage or the criterion time may be calculated or modified by the first diagnosis module 200 or the like.

Meanwhile, the measurement module 100 may measure state information of the battery periodically and/or non-periodically. For example, a voltage sensor serving as the measurement module 100 may measure the voltage of the battery with a period of 50 ms. Also, the state information (voltage measurement value) measured periodically like this may be transmitted to the first diagnosis module 200. Then, the first diagnosis module 200 may judge whether the voltage measurement value satisfies the first diagnosis criterion and the criterion time in consideration of the voltage measurement value and the measurement period, and determine the abnormal state of the battery.

According to this embodiment of the present disclosure, an abnormal situation of the battery may be diagnosed more accurately. In particular, the abnormal state of the battery is determined based on the measurement value by the measurement module 100, such as a voltage sensor, and measurement errors may occur due to temporary errors or noise in the measurement module 100. However, according to this embodiment, since it considers whether the measurement value is maintained for a certain period of time or more, incorrect diagnosis due to such measurement error may be prevented. For example, in the embodiment of FIG. 4, the voltage behavior measured between the ta1 time point and the ta2 time point is temporary and may be due to a measurement error. In this case, the first diagnosis module 200 may improve the accuracy of diagnosing an abnormality of the battery by not diagnosing this situation as abnormal.

The second diagnosis module 300 may be configured to diagnose an abnormality in situations where abnormality is not diagnosed by the first diagnosis module 200.

For example, the second diagnosis module 300 may diagnose the battery as in an abnormal situation before the first diagnosis module 200 diagnoses the battery as in an abnormal situation. More specifically, when diagnosing whether the battery has low voltage, the first diagnosis module 200 diagnoses the battery as normal, but the second diagnosis module 300 may diagnose the battery as abnormal first.

In particular, in the embodiment of FIG. 3, even if the battery is not diagnosed as abnormal by the first diagnosis module 200 because either the criterion voltage or the criterion time is not satisfied, the same battery may be diagnosed as abnormal first by the second diagnosis module 300.

For example, in the embodiment of FIG. 3, even if the voltage measurement value is 3.1V or less, the first diagnosis module 200 may not diagnose the battery as abnormal before the state of 3.1V or less is maintained for 1 second or more. However, even before the first diagnosis module 200 diagnoses the battery as abnormal, namely even before the state of 3.1V or less is maintained for 1 second or more, the second diagnosis module 300 may diagnose the corresponding battery as abnormal based on the state information change amount (voltage change amount).

The second diagnosis module 300 may diagnose whether the battery is abnormal or in an abnormal state, like the first diagnosis module 200. At this time, the abnormality diagnosed by the second diagnosis module 300 may diagnose the same situations as the abnormal situation diagnosed by the first diagnosis module 200. For example, the first diagnosis module 200 and the second diagnosis module 300 may diagnose low voltage as the abnormal situation of the battery. However, the abnormal level diagnosed by the first diagnosis module 200 and the abnormal level diagnosed by the second diagnosis module 300 may be different. This will be described in more detail with reference to FIG. 5 along with FIG. 3.

FIG. 5 is a diagram schematically showing an example of a low voltage diagnosis criterion for the battery by a second diagnosis module 300 according to an embodiment of the present disclosure.

Referring to FIG. 5, the second diagnosis module 300 may be configured to diagnose whether the battery has low voltage. At this time, the second diagnosis module 300 may be configured to distinguish whether the voltage of the battery is in a normal (Normal) state or an abnormal (low voltage) state. In other words, the second diagnosis stage divided by the second diagnosis module 300 may be divided into two levels (E1, E2) with respect to the state of the battery. In particular, the second diagnosis module 300 may be configured to diagnose only a failure (Failure) stage as an abnormal state of the battery. Here, the failure stage (Level E2) by the second diagnosis module 300 may represent the same state as the failure stage (Level C5) by the first diagnosis module 200 shown in FIG. 3.

In other words, the abnormal state of the battery may be diagnosed to be classified into several stages by the first diagnosis module 200, and the abnormal state diagnosed by the second diagnosis module 300 may be at a level equivalent to the abnormal level of the worst state among several abnormal levels diagnosed by the first diagnosis module 200. For example, the second diagnosis module 300 may diagnose as abnormal only when the low voltage level of the battery is at a level that could lead to failure, and diagnose the remaining situations as normal. Meanwhile, even if the low voltage of the battery is not at a level that could lead to failure, the first diagnosis module 200 may not diagnose the low voltage as normal, but diagnoses it as an abnormal state (warning, danger, fault) that is less serious than failure.

In this embodiment, the second diagnosis module 300 may diagnose as an abnormal state only for emergency situations in which the level of the abnormal state is the most severe. Therefore, it may be regarded that the first diagnosis module 200 is prepared to perform ordinary diagnosis, and the second diagnosis module 300 is prepared to perform emergency diagnosis. According to this embodiment of the present disclosure, for abnormal situations such as low voltage or overvoltage of the battery, ordinary diagnosis (first diagnosis) using the first diagnosis module 200 and emergency diagnosis (second diagnosis) using the second diagnosis module 300 may be performed together. Therefore, complex diagnosis may be performed for abnormal situations of the battery, and diagnosis performance may be further improved through mutual complementation between diagnoses.

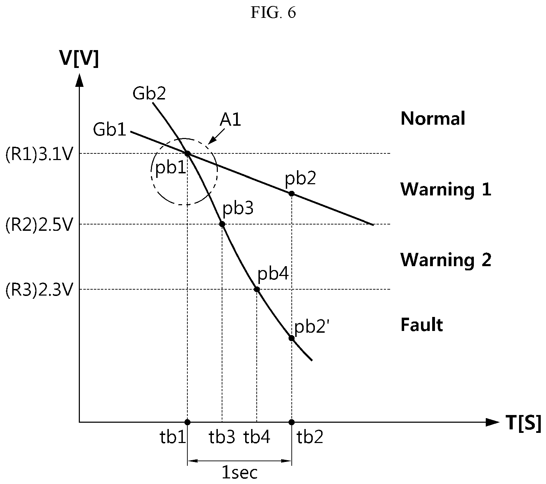

In particular, according to one embodiment of the present disclosure, the battery may be diagnosed more accurately in situations where the state of the battery changes rapidly. This will be explained in more detail with reference to FIG. 6.

FIG. 6 is a graph showing voltage measurement values of the battery according to different embodiments of the present disclosure. In particular, FIG. 6 may be regarded as showing a voltage graph for the battery discharge situation.

In the embodiment of FIG. 6, graphs Gb1, Gb2 for two different voltage measurement results are shown. In addition, FIG. 6 shows the criterion voltage serving as a diagnosis criterion for diagnosing an abnormal situation for the voltage measurement result, and shows whether the battery is abnormal along with the abnormal state of the battery distinguished by each diagnosis criterion.

More specifically, in the embodiment of FIG. 6, similar to the former embodiment of FIG. 3, the criterion voltage R1 that distinguishes between normal (Normal) and warning (Warning 1) is set to 3.1V, the criterion voltage R2 that distinguishes between warning (Warning 1) and danger (Warning 2) is set to 2.5V, and the criterion voltage R3 that distinguishes between danger (Warning 2) and fault (Fault) is set to 2.3V. This classification of the criterion voltage and the abnormal state may be used or performed by the first diagnosis module 200. Also, similar to the former embodiment of FIG. 3, the first diagnosis module 200 may consider the criterion time corresponding to each stage to determine each abnormal state. For example, the first diagnosis module 200 may consider whether the voltage measurement value of 3.1 V or less is maintained for 1 second or more to diagnose the warning stage.

In this situation, referring to the Gb1 graph first, the voltage measurement value goes to 3.1V or below at the pb1 point. At this time, the first diagnosis module 200 may diagnose the corresponding battery as in a warning (Warning 1) stage, which is the initial level of the abnormal state, at the tb2 time point, at which 1 second, which is the criterion time, has passed from the tb1 time point corresponding to the pb1 point. Referring to the Gb1 graph, the battery voltage at the tb2 time point when the warning stage is diagnosed may be regarded as being the pb2 point. Also, the pb2 point may be regarded as still existing at a level corresponding to the warning stage. Therefore, the diagnosis of the first diagnosis module 200 may be considered as being performed appropriately. Therefore, in this embodiment, appropriate judgment and response may be made only through diagnosis by the first diagnosis module 200.

Next, referring to the Gb2 graph, like the Gb1 graph, the voltage measurement value goes to 3.1V or below at the pb1 point. However, the Gb2 graph shows a very steep slope compared to the Gb1 graph. This may be regarded as representing a situation in which the battery corresponding to the Gb2 graph discharges very rapidly compared to the battery corresponding to the Gb1 graph. In this situation, the battery may not be accurately diagnosed with only the first diagnosis module 200.

For example, in the Gb2 graph, the first diagnosis module 200 may diagnose the battery as in an abnormal state, such as a warning state, only at the tb2 time point, at which 1 second, which is the criterion time, has passed from the tb1 time point. However, in the Gb2 graph, the voltage measurement value has already passed the pb3 point, which is the lower boundary of the warning (Warning 1) stage, and the pb4 point, which is the lower boundary of the danger (Warning 2) stage, at the tb3 time point and tb4 time point at which 1 second has not passed from the tb1 time point. Also, the pb2' point, at which 1 second has passed from the tb1 time point, is already in the fault (Fault) stage. In this situation, the first diagnosis module 200 may diagnose an abnormal state, especially a warning state, only at the tb2 time point. Therefore, it is not possible to quickly and accurately diagnose whether the battery is abnormal or the abnormal state of the battery with only the first diagnosis module 200.

However, in a battery discharge situation such as the Gb2 graph, even if the first diagnosis module 200 does not accurately diagnose whether the battery is abnormal or the state of the battery, according to one embodiment of the present disclosure, the second diagnosis module 300 may diagnose whether the battery is abnormal. For example, even in a situation where the low voltage situation of the battery cannot be diagnosed by the first diagnosis module 200 because the low voltage situation of the battery does not satisfy the criterion time, the second diagnosis module 300 may diagnose the low voltage situation of the battery.

In particular, a situation where the discharge voltage of the battery drops rapidly as shown in the Gb2 graph is a very unusual situation rather than an ordinary discharge situation, and the second diagnosis module 300 may perform an emergency diagnosis for this unusual situation. Moreover, the second diagnosis module 300 may diagnose the abnormal situation of the battery as one stage, rather than diagnosing the abnormal situation of the battery into several stages like the first diagnosis module 200. In this case, a more rapid and urgent diagnosis may be possible using the second diagnosis module 300. Moreover, the abnormal situation diagnosed by the second diagnosis module 300 may correspond to the most serious level among several abnormal situations diagnosed by the first diagnosis module 200. Therefore, appropriate follow-up measures may be taken by the apparatus for managing a battery according to the present disclosure.

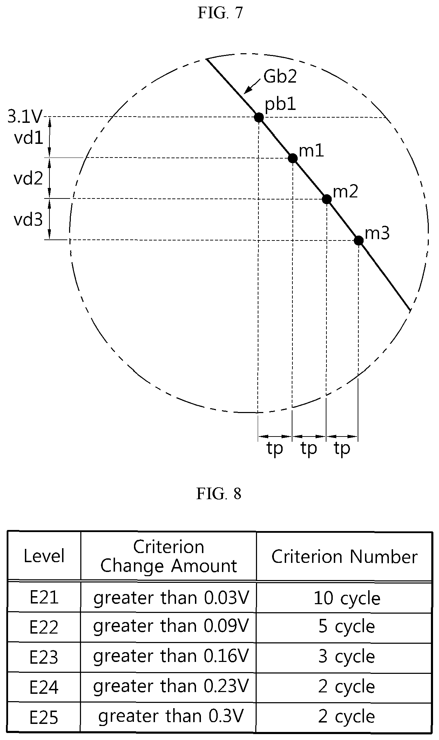

In a situation where the state (ex. voltage) of the battery changes rapidly as in the Gb2 graph, the configuration in which the second diagnosis module 300 diagnoses whether the battery is abnormal will be described in more detail with reference to FIG. 7.

FIG. 7 is a graph schematically showing the configuration for diagnosing whether the battery is abnormal by the second diagnosis module 300 according to an embodiment of the present disclosure. For example, FIG. 7 may be an enlarged view showing the portion A1 in the Gb2 graph of FIG. 6.

Referring to FIG. 7, the measurement module 100 may periodically measure state information of the battery, such as voltage information. In FIG. 7, the voltage measurement period is indicated as tp. For example, the voltage measurement period (tp) may be 50 ms. In the graph of FIG. 7, the state information measured periodically from the point (pb1) where the voltage is 3.1V is displayed as m1, m2, and m3.

If the voltage measurement information is received from the measurement module 100, the second diagnosis module 300 may be configured to calculate the change amount of the state information (voltage information). At this time, the second diagnosis module 300 may calculate the change amount of the state information using the currently measured state information and the previously measured state information. In particular, the second diagnosis module 300 may use the currently measured state information and the state information measured in the just previous period to calculate the change amount of the state information. For example, the second diagnosis module 300 may calculate the change amount between the voltage of the battery at the pb1 point and the voltage of the battery at the m1 point after 1 measurement period as vd1. Also, the second diagnosis module 300 may diagnose whether the battery at the m1 point is abnormal through the difference (vd1) between the just previous measurement value and the current measurement value.

The second diagnosis module 300 may diagnose whether the battery is abnormal by comparing the change amount of the state information with a second diagnosis criterion. In particular, the second diagnosis module 300 may diagnose the battery as abnormal if the change amount of the state information of the battery deviates from the second diagnosis criterion.

Here, the second diagnosis criterion may include a criterion value to be compared with the change amount of the state information calculated by the second diagnosis module 300. For example, the second diagnosis criterion is a criterion for diagnosing the low voltage of the battery and may include a criterion change amount for the voltage of the battery. Moreover, when the second diagnosis module 300 diagnoses whether the battery has low voltage using the voltage change amount of the battery, the criterion change amount serving as the second diagnosis criterion may be a value representing the range of voltage change amount that can appear when the battery is in a normal state, especially a maximum value.

As a more specific example, referring to FIG. 5, the criterion change amount serving as the second diagnosis criterion may be set to 0.03V. In this case, the second diagnosis module 300 may determine that the corresponding battery is abnormal if the voltage change amount of the battery is greater than the criterion change amount (0.03V). Here, the voltage change amount or the criterion change amount is expressed as an absolute value, and only its magnitude can be compared.

For example, in a discharge situation where the voltage value decreases over time, if the voltage measurement value of the previous period is subtracted from the voltage measurement value of the current period, the voltage change amount may be calculated as a negative (-) value. However, the voltage change amount is converted to an absolute value and expressed in a form with the minus sign removed, and then its magnitude may be compared with the criterion change amount. In a state where the battery is discharged, if the voltage change amount (absolute value) exceeds the criterion change amount (absolute value), the battery may be determined as in a low voltage state. Meanwhile, in a situation where the battery is being charged, if the voltage change amount exceeds the criterion change amount, the battery may be determined as in an overvoltage state. Of course, the voltage change amount or the criterion change amount may be a concept that considers signs (+, -) rather than absolute values.

Meanwhile, the second diagnosis criterion such as the criterion change amount in FIG. 5 may be stored in the second diagnosis module 300 or the memory 400. Alternatively, the second diagnosis criterion may be calculated by the second diagnosis module 300 or the like, or may be transmitted to the second diagnosis module 300 from another external component. For example, the second diagnosis criterion may be input from a user through an input device, or may be transmitted to the second diagnosis module 300 from an external server or the like through a wired or wireless communication network.

According to this embodiment, in a situation where the state of the battery, such as voltage, changes rapidly, the battery may be diagnosed made more quickly and accurately. Furthermore, the first diagnosis module 200 may specifically diagnose whether the battery is abnormal in an ordinary state. However, when the first diagnosis module 200 considers the duration time, if the abnormal state of the battery changes rapidly, the abnormal state may not be properly diagnosed. However, according to this embodiment, an abnormal state accompanied by a rapid change in the battery may be diagnosed by the second diagnosis module 300. Therefore, by mutual complementation of the diagnosis by the first diagnosis module 200 and the second diagnosis module 300, an appropriate diagnosis may be possible depending on the situation.

The second diagnosis module 300 may be configured to diagnose whether the battery is abnormal by considering the number of times the change amount of the state information deviates from the second diagnosis criterion. In particular, the second diagnosis module 300 may compare the number of times the change amount of the state information deviates from the second diagnosis criterion (deviation number) with a criterion number. Also, the second diagnosis module 300 may be configured to diagnose whether the battery is abnormal according to the comparison result. Here, the 'number of times' may refer to the number of measurement cycles in which the change amount of the state information is measured to deviate from the second diagnosis criterion when the battery is measured periodically.

For example, seeing the embodiment of FIG. 7, the voltage information may be measured periodically by the measurement module 100. At this time, if the measurement period (tp) is 50 ms, the voltage information of the battery may be measured at every 50 ms, and through this, the second diagnosis module 300 may measure the voltage change amount of the battery at every 50 ms. In FIG. 7, the value measured in the period following the pb1 point corresponds to the m1 point, and the voltage change amount between the pb1 point and the m1 point is vd1. Also, the voltage change amount between the m1 point and the m2 point measured in the next period is vd2, and the voltage change amount between the m2 point and the m3 point measured in the next period is vd3. At this time, if the values of vd1, vd2, and vd3 all exceed the criterion change amount (ex. 0.03V), the second diagnosis module 300 may calculate the number of deviations as 3 times (3 cycles). As another example, when vd1 and vd2 exceed the criterion change amount and vd3 does not exceed the criterion change amount, the second diagnosis module 300 may calculate the number of deviations as two times (2 cycles).

In this way, the second diagnosis module 300 may calculate the number of deviations for the change amount of the state information, and diagnose that the battery is abnormal if the number of deviations exceeds the criterion number. Here, the criterion number is a value or range to be compared with the number of deviations, and for example, the criterion number may be set as the minimum number of times to diagnose the battery as abnormal. The criterion number may be stored in advance in the second diagnosis module 300 or the battery module, or may be calculated under certain conditions. For example, as shown in the table of FIG. 5, 10 cycles may be set as a criterion number for diagnosing a battery as a failure (Failure). In this case, when the number of times the voltage change amount exceeds the criterion change amount is 10 times (cycles) or more, the second diagnosis module 300 may diagnose the corresponding battery as failure.

According to this embodiment, when the battery is diagnosed as abnormal by the second diagnosis module 300, the accuracy of the diagnosis may be improved. For example, a measurement error in the measurement module 100 may occur in a specific measurement cycle, but the problem of incorrectly diagnosing the battery as abnormal due to temporarily occurring errors or mistakes may be prevented.

In this embodiment, in the number of deviations or the criterion number considered by the second diagnosis module 300, the 'number' may be understood in terms of time. For example, when measured with a period of 50 ms, the criterion number set to 10 cycles may be changed by applying the criterion time as 500 ms (0.5 seconds). At this time, the criterion time (second criterion time) considered by the second diagnosis module 300 may be set differently from the criterion time (first criterion time) considered by the first diagnosis module 200 in the former embodiment of FIG. 3. In particular, since the second diagnosis module 300 may perform a diagnosis of a more urgent situation than the first diagnosis module 200, the second criterion time may be set shorter than the first criterion time. For example, the first criterion time may be set to 1 second, and the second criterion time may be set to 0.5 seconds. That is, the criterion number considered by the second diagnosis module may be determined as a value that, when converted to time units, is shorter than the criterion time considered by the first diagnosis module.

The second diagnosis module 300 may be configured to sum up the number of deviations that are not continuous, namely the number of discontinuous deviations, and compare the number with a criterion number.

For example, it is assumed that the measurement change amount exceeds the criterion change amount in the first to fourth measurement cycles, the measurement change amount does not exceed the criterion change amount in the fifth measurement cycle, and then the measurement change amount exceeds the criterion change amount in the sixth and seventh measurement cycles. In this case, the number of deviations in the first to fourth measurement cycle is 4, and the number of deviations in the sixth to seventh measurement cycle is 2. Although the four deviation cases and the two deviation cases are discontinuous, the number of deviations thereof may be added together. Therefore, the second diagnosis module 300 may calculate the number of deviations in the first to seventh measurement cycles as 6 and then compare the number with the criterion number.

According to this embodiment, continuous monitoring may be possible for situations where an abnormal situation such as sudden discharge is temporarily interrupted or in a lull state. Therefore, according to this embodiment, even if an emergency situation with rapid discharge occurs again after a temporary interruption of an abnormal situation, it is possible to appropriately diagnose and respond to the situation.

However, in this embodiment, the second diagnosis module 300 may be configured to add up the number of discontinuous deviations only when the deviation cases are within a certain number of times. Here, the certain number of times subject to adding-up may be set in various ways depending on various conditions or situations, such as battery specifications, type, and operating state.

For example, if a deviation case (first deviation case) is diagnosed in the first to fifth measurement cycle and also a deviation case (second deviation case) is diagnosed after a considerable time has passed, for example in the 500th to 505th measurement cycles, it may be regarded that a considerable amount of time has passed between the first deviation case and the second deviation case. Therefore, it may be predicted that the correlation between the first deviation case and the second deviation case is not high. Therefore, in this case, the second diagnosis module 300 may compare each deviation number with the criterion number without adding up the number of deviations of the first deviation case and the number of deviations of the second deviation case.

The criterion number considered when performing a second diagnosis operation by the second diagnosis module 300 may be set differently depending on the situation. In particular, the criterion number may have different values depending on the change amount of state information. This will be described in more detail with reference to FIG. 8.

FIG. 8 is a table schematically showing a low voltage diagnosis criterion of the battery by a second diagnosis module 300 according to another embodiment of the present disclosure.

Referring to FIG. 8, a plurality of criterion change amounts are included corresponding to the plurality of levels E21 to E25. Here, the criterion change amount may be a criterion value to be compared with the change amount for the state information of the battery. For example, when a low voltage or overvoltage situation is diagnosed based on the voltage information of the battery, the criterion change amount is a value compared to the voltage change amount and may be expressed in voltage units such as 'volt (V)'.

Also, the criterion change amount may be expressed as a specific value or specific range. For example, in FIG. 8, only the lower limit value of the criterion change amount for each level is displayed, and the upper limit value may be related to the lower limit value of the next level. For example, the lower limit of the E21 level is described as 'greater than 0.03V', and the lower limit of the E22 level, which the next level, is 'greater than 0.09V', so the upper limit of the E21 level may be expressed as '0.09V or less'. Therefore, the E21 level may be expressed as 'greater than 0.03V, and 0.09V or less'. Also, the upper limit of each level for the E22 and E23 levels may be set in the same manner.

Moreover, the various levels E21 to E25 shown in FIG. 8 may be a subdivision of the abnormal level E2 (Failure) shown in FIG. 5. That is, in the embodiment of FIG. 5, the case of greater than 0.03V is classified as abnormal, and in the embodiment of FIG. 8, the abnormal situation of greater than 0.03V is divided again into several levels in a subdivided form according to the magnitude of the voltage change amount.

As in the embodiment of FIG. 8, a criterion number may be set to correspond to each criterion change amount. Moreover, the criterion number may have different values depending on the criterion change amount. In other words, the criterion number considered by the second diagnosis module 300 when performing the second diagnosis operation may be determined depending on the level of the change amount of the state information, namely depending on the range of the criterion change amount within which the change amount of the state information is included. Therefore, it may be regarded that the criterion number has different values depending on the change amount of the state information of the battery.

More specifically, in the embodiment of FIG. 8, for the E21 level, the criterion change amount is 0.03V to 0.09V, and the criterion number is 10 cycles. Also, for the E22 level, the criterion change amount is 0.09V to 0.16V, and the criterion number is 5 cycles. Also, for the E23 level, the criterion change amount is 0.16V to 0.23V, and the criterion number is 3 cycles. Also, for the E24 level, the criterion change amount is greater than 0.23V, and the criterion number is 2 cycles. Also, finally, for the E25 level, the criterion change amount is greater than 0.3V and the criterion number is 2 cycles.

In particular, the criterion number may be set, at least partially, to have a lower value as the criterion change amount increases. For example, in the embodiment shown in FIG. 8, the criterion change amount may be regarded as increasing from the E21 level to the E24 level, such as greater than 0.03V, greater than 0.09V, greater than 0.16V, and greater than 0.23V. Also, as the criterion change amount increases, the criterion number may gradually decrease, such as 10 cycles, 5 cycles, 3 cycles, and 2 cycles.

Here, the criterion number for each level may be stored in advance in the memory 400 or the second diagnosis module 300, or calculated by the second diagnosis module 300 or the like. Furthermore, the criterion number may be calculated as a value just before the state information of the battery leads to failure or the like, when the state information of the battery, such as voltage, changes according to the current trend. In particular, assuming that the state information change amount is as large as possible in the corresponding section, the criterion number for each level may be determined as a value that measures as much as possible, but does not lead to a serious situation such as failure.

For example, seeing the embodiment of FIG. 3, the start of the abnormal situation for the battery may be 3.1V, and the failure situation, which is the most serious abnormal situation, may be when the voltage of the battery is 2V or less. In this case, the criterion number may be determined as 2.1V to 2.2V, which ensures that the battery voltage does not fall to 2V or below and secures a small safety margin at 2V for more accurate diagnosis of abnormal situations. As a more specific example, in the embodiment of FIG. 8, seeing the E21 level, the criterion change amount may be 0.03V to 0.09V. The worst situation in the E21 level is 0.09V. Therefore, the criterion number for the E21 level may be determined as follows, using that the starting voltage of the abnormal situation is 3.1V, the lowest voltage that secures a safety margin is 2.1V, and the largest voltage change amount is 0.09V in the corresponding section.

$$3.1-(0.09*X)>2.1$$

(X is a criterion number)

$$X<11.11....$$

Here, the criterion number X may be determined to be a number of 11 or less. At this time, X may be determined to be 10 by subtracting 1 as a concept to provide an additional safety margin. In this case, as shown in FIG. 8, the criterion number for the E21 level may be set to 10 cycles. In this embodiment, the criterion number of 10 cycles may be regarded as the number of measurements (number of measurement cycles) that considers as many times as possible in the voltage change amount state corresponding to the E21 level section, but does not lead the battery to failure. On the other hand, in this specification, '*' may mean 'multiplication ($\times$)' of a formula.

In the embodiment of FIG. 8, other levels, namely the E22 to E25 levels, may also be calculated in the same way. For example, in the E22 level, considering 0.16V, which is the upper limit of the corresponding level or the lower limit of the E23 level, which is the next level, the criterion number may be determined using the following relational expression.

$$3.1-(0.16*X)>2.1$$

$$X<6.25$$

At this time, the criterion number may be determined as a value less than or equal to 6, for example 5 that is smaller than 6 by 1.

Meanwhile, the E25 level, which has the highest voltage range in the embodiment of FIG. 8, may not be an upper limit or next level. In this case, the criterion number of the E25 level may be set to 2 cycles, like the E24 level. In particular, the criterion number considered when the second diagnosis operation is performed by the second diagnosis module 300 may be set to at least 2 cycles or more to prevent incorrect diagnosis due to measurement error or the like. Also, of course, if the voltage change amount is too large, the criterion number may be set to 1.

In this embodiment, the second diagnosis module 300 may determine the level section to which the change amount of the state information of the battery, for example the voltage change amount of the battery, belongs to. Also, the second diagnosis module 300 may determine whether the criterion number of the level to which the voltage change amount of the battery belongs is satisfied. Here, the second diagnosis module 300 may finally diagnose that the battery is abnormal if the number of measurements (number of measurement cycles) of the battery voltage change amount is greater than or equal to the criterion number of the corresponding level.

For example, if the voltage change amount of the battery is 0.06V, the second diagnosis module 300 may determine that the battery belongs to the E21 level and determine the criterion number as 10 cycles. In addition, if it is determined that the number of times the voltage change amount of the battery is measured to be greater than 0.03V is 10 or more, the second diagnosis module 300 may diagnose the corresponding battery as abnormal, especially failure (Failure).

As another example, if the voltage change amount of the battery is 0.19V, the second diagnosis module 300 may determine that the battery belongs to the E23 level and determine the criterion number as 3 cycles. In addition, if it is determined that the number of times the voltage change amount of the battery is measured to be greater than 0.16V is 3 or more, the second diagnosis module 300 may diagnose the corresponding battery as abnormal.

Meanwhile, the second diagnosis module 300 may be configured to calculate a criterion number according to the current battery state or to change the criterion number that is already calculated or stored. Moreover, in the embodiment of diagnosing low voltage, the second diagnosis module 300 may calculate a criterion number according to the voltage measurement value.

For example, in this embodiment, the criterion number is set using that the starting voltage of the abnormal situation is 3.1V, but if the currently measured voltage measurement value is lower than 3.1V, the second diagnosis module 300 may calculate or change the criterion number according to the currently measured voltage measurement value.

More specifically, in the embodiment of FIG. 8, for the criterion change amount of 0.03V to 0.09V corresponding to the E21 level, the second diagnosis module 300 may calculate the criterion number as follows.

$$2.5-(0.09*X)>2.1$$

$$X<4.44...$$

In this case, the second diagnosis module 300 may set the criterion number to 3 for the E21 level (0.03V to 0.09V). In addition, if the voltage change amount is measured three or more times to be within the range of 0.03V to 0.09V, the second diagnosis module 300 may diagnose that the corresponding battery has a low voltage failure.

Meanwhile, the criterion number calculated by the second diagnosis module 300 may be stored or updated on its own or in the memory 400 or the like.

If the change amount of the state information changes, the second diagnosis module 300 may be configured to perform diagnosis by changing the criterion number. That is, while the second diagnosis operation is performed based on the criterion number derived based on a specific state information change amount, if the corresponding state information change amount changes, the second diagnosis module 300 may change the criterion number. Also, the second diagnosis module 300 may diagnose the abnormal state of the battery according to the changed criterion number.

In particular, in the configuration for low voltage or overvoltage diagnosis, the second diagnosis module 300 may derive the corresponding first criterion number according to the first voltage change amount, which is the current voltage change amount. In addition, the second diagnosis module 300 may perform a second diagnosis operation by examining whether the corresponding battery satisfies the first criterion number in a state that satisfies the first voltage change amount. However, if the voltage change amount is changed to the second voltage change amount later, the second diagnosis module 300 may newly derive a second criterion number corresponding to the second voltage change amount. In addition, the second diagnosis module 300 may continuously perform the second diagnosis operation by determining whether the battery is abnormal according to the newly derived second criterion number.

In particular, if the state information change amount changes during the second diagnosis operation so that the level changes, the second diagnosis module 300 may be configured to apply a criterion number of a high level. Here, the high level may mean a level in a state where the state information change amount is relatively worse.

For example, in the embodiment of FIG. 8, if the voltage change amount of the battery is 0.05V and belongs to the E21 level, the second diagnosis module 300 may determine the criterion number to be 10 cycles and judge whether the number of cycles the voltage change amount is greater than 0.03V is 10 or more. However, in the third measurement cycle, if the voltage change amount of the battery increases to 0.12V, the state level may change to E22. Also, the criterion number for the E22 level is 5 cycles. In this case, the higher level between the E21 level and the E22 level may be regarded as the E22 level, where the voltage change amount is more severe. Therefore, the second diagnosis module 300 determines the criterion number as 5 cycles corresponding to the E22 level, and if the voltage change amount is greater than 0.09V in the 4th and 5th cycles thereafter, the criterion number of 5 is satisfied, so the corresponding battery may be diagnosed as abnormal (low voltage failure).

Moreover, as the state information change amount increases, the criterion number may decrease, so in this case, a high level may mean a level where the criterion number is low. Therefore, when the change amount of the state information changes in two or more level sections, the second diagnosis module 300 may perform a second diagnosis operation using the lowest criterion number among the levels.

For example, in the embodiment of FIG. 8, when the voltage change amount changes between the E21 section and the E23 section, the second diagnosis module 300 may set 3 cycles corresponding to the E23 level section as the criterion number as the lowest criterion number. Therefore, the second diagnosis module 300 may diagnose the battery as being in an abnormal state if a situation of 0.03V or above is measured three or more times.

When the measurement module 100 measures state information about the battery periodically, the criterion number may be expressed in time units. For example, the voltage change amount of the battery may be measured in a period of 50 ms by the measurement module 100. At this time, if the criterion number is 10 cycles, the criterion number may be expressed as a time of 500 ms (0.5 seconds).

At this time, the criterion number considered by the second diagnosis module 300 may be configured to be shorter than the criterion time considered by the first diagnosis module 200. For example, the criterion time for each level considered by the first diagnosis module 200 may be set to 1 second or more, as shown in FIG. 3. Meanwhile, the criterion number for each level considered by the second diagnosis module 300 may be set to a maximum of 0.5 seconds or less when converted to time, as shown in FIG. 8.

According to this embodiment, the first diagnosis module 200 may more accurately diagnose an abnormal situation of the battery, and the second diagnosis module 300 may more quickly diagnose an emergency situation among the abnormal situations of the battery. Therefore, in this case, diagnosis by the first diagnosis module 200 and the second diagnosis module 300 may be performed complementarily to each other.

The second diagnosis module 300 may be configured to compare the state information measured by the measurement module 100 with a third diagnosis criterion. Also, the second diagnosis module 300 may be configured to operate when, as a result of this comparison, the measured state information deviates from the third diagnosis criterion. In other words, the second diagnosis module 300 may not operate in general situations, but may be configured to operate only in specific situations. Here, the specific situation may be a case where the state information of the battery deviates from the third diagnosis criterion.

The third diagnosis criterion is a condition for the second diagnosis module 300 to start operation, and may be stored in advance in the second diagnosis module 300 or the memory 400. Alternatively, the third diagnosis criterion may be calculated separately by the second diagnosis module 300.

For example, referring to FIG. 5, a second criterion voltage is indicated as another condition for determining failure (Failure). Also, this second criterion voltage may be the third diagnosis criterion. In particular, the second criterion voltage for the E2 level diagnosed as failure is set to 3.1V or less. In this embodiment, the second diagnosis module 300 may first determines whether the battery voltage is 3.1V or less before determining whether the criterion change amount exceeds 0.03V and the number of excesses is equal to or greater than the criterion number (10 cycles).

If the battery voltage transmitted by the measurement module 100 exceeds 3.1V, the second diagnosis module 300 does not need to determine whether the criterion change amount exceeds 0.03V or whether the number of such excesses is equal to or greater than the criterion number. Furthermore, the second diagnosis module 300 may not calculate the voltage change amount of the battery if the measurement voltage of the battery exceeds 3.1V.

Meanwhile, if the battery voltage transmitted by the measurement module 100 satisfies the second criterion voltage (third diagnosis criterion) condition (3.1V or less) for the E2 level indicating an abnormal state (Failure), the second diagnosis module 300 may finally initiate the second diagnosis operation. For example, when the voltage of the battery is 3.0V, the second criterion voltage for the E2 level in FIG. 5 is satisfied, so the second diagnosis module 300 may calculate the voltage change amount of the battery. Also, the second diagnosis module 300 may determine whether the voltage change amount of the battery exceeds the criterion change amount, and if so, whether the number of times of such excess is equal to or greater than the criterion number. At this time, if the voltage change amount exceeds 0.03V and the number of times of excess is 10 cycles or more, the second diagnosis module 300 may diagnose the battery as failure (Failure).

The third diagnosis criterion considered during the second diagnosis operation of the second diagnosis module 300 may be set to be identical or similar to the first diagnosis criterion considered during the first diagnosis operation of the first diagnosis module 200. In particular, the criterion for determining normal and abnormal in the third diagnosis criterion may be set to be the same as the criterion for determining normal and abnormal in the first diagnosis criterion. In particular, when there are multiple first diagnosis criteria to classify the abnormal state into a plurality of diagnosis stages, the third diagnosis criterion may be set to be the same as the criterion for the lowest level abnormal state among the abnormal states. In other words, the third diagnosis criterion may be set as an initial diagnosis criterion that distinguishes normal from abnormal among the plurality of first diagnosis criteria. For example, in FIG. 3, among the plurality of first diagnosis criteria (first criterion voltage), the initial diagnosis criterion that distinguishes normal (Normal) and warning (Warning 1) is 3.1V or less. At this time, the second diagnosis criterion, as shown in FIG. 5, may be set to be the same as the initial diagnosis criterion (3.1V or less) in FIG. 3.

According to this embodiment of the present disclosure, the second diagnosis module 300 may operate efficiently. In particular, when the battery is likely to be in a normal state, the second diagnosis module 300 may not be operated, thereby preventing unnecessary power or resource consumption due to the second diagnosis operation.

The second diagnosis module 300 may be configured to perform an appropriate response operation according to the diagnosis operation (second diagnosis operation). In other words, the second diagnosis module 300 may diagnose whether the battery is abnormal based on the change amount of the state information measured for the battery and perform a corresponding processing operation based on the diagnosis result. In particular, the second diagnosis module 300 may be configured to block the charging operation or discharging operation of the battery when the battery is diagnosed as abnormal.

For example, seeing the embodiment of FIG. 5 that diagnoses whether the battery is in low voltage, if the measurement voltage of the battery is 3.1V or less, the voltage change amount exceeds 0.03V, and the number of times of excess is determined to be 10 cycles or more, the second diagnosis module 300 may diagnose the corresponding battery as low voltage-related failure (Failure). In addition, the second diagnosis module 300 may immediately turn off the charging and discharging switch so that the charging and discharging current for the corresponding battery is blocked along with the diagnosis of failure.

If an abnormality is diagnosed by the second diagnosis module 300, there is a high possibility that this is a very serious emergency situation among the abnormal situations. Therefore, according to this embodiment, by stopping the charging and discharging operation of the battery in response to the emergency situation, it is possible to prevent problems such as damage, failure, thermal runaway, ignition, or explosion from occurring in the battery.

Meanwhile, when a battery module or battery pack includes a plurality of batteries, each battery may be referred to as a battery cell. At this time, the apparatus for managing a battery according to the present disclosure may perform a diagnosis operation and/or a response operation for each battery cell or each grouped battery cells (cell group). In particular, when the low voltage or overvoltage of the battery is serious, it is possible to prevent the low voltage or overvoltage situation from worsening for the corresponding cell or cell group by stopping the charging and discharging operation for some battery cells or cell groups. At this time, the apparatus for managing a battery according to the present disclosure may enable other normal battery cells to perform operations such as charging and discharging as is.

In addition, the diagnosis-based response operation of the second diagnosis module 300 may be implemented in various other forms or methods, such as warning the user or transmitting related information to other components. Here, other components may be a component included within the apparatus for managing a battery according to the present disclosure, or may be a component included in another device existing outside the apparatus for managing a battery. In particular, when the target battery is mounted on a vehicle such as a two-wheeled vehicle, the apparatus for managing a battery according to the present disclosure may transmit the information on the diagnosis operation, such as that the target battery is diagnosed as being in a failure state, or the response operation, such as that charging and discharging is blocked, to a higher-level control system on the vehicle, such as a VCU (Vehicle Control Unit) or ECU (Energy Control Unit).

Also, the first diagnosis module 200 may be configured to perform appropriate response operations according to the diagnosis operation (first diagnosis operation).

For example, the first diagnosis module 200 may transmit or store the information about the diagnosis stage to/in other components as a corresponding operation for the diagnosis stage of the target battery. For example, if the target battery is diagnosed as being in the Warning1 (warning) stage, the control module 200 may transmit the information that the target battery is diagnosed as being in the Warning1 (warning) stage to other components.

The first diagnosis module 200 and/or the second diagnosis module 300 may include a display unit or may provide related data to an external display device in order to provide the diagnosis result to the user. For example, the first diagnosis module 200 and/or the second diagnosis module 300 may transmit the diagnosis result to a system on the vehicle, and the vehicle may provide the diagnosis result to the occupants through a vehicle monitor.

The first diagnosis module 200 may be configured to control the battery charging or discharging operation based on the first diagnosis operation. For example, the first diagnosis module 200 may reduce the charging and discharging current of the battery, or stop the charging and discharging, depending on the diagnosis result of the battery.

In particular, if the abnormal state of the target battery is diagnosed to be classified into several diagnosis stages, the first diagnosis module 200 may perform an individual response action for each diagnosis stage. For example, in the embodiment of FIG. 3, the first diagnosis module 200 may display only warning information to the user when the diagnosis level of the battery is C2 and C3, and reduce the magnitude of the charging and discharging current of the battery or shorten the charging and discharging time when the diagnosis level of the battery is C4. Also, the first diagnosis module 200 may completely block the charging and discharging current of the battery when the diagnosis level of the battery is C5.

The second diagnosis module 300 may be configured to operate with priority over the first diagnosis module 200. That is, according to one embodiment of the present disclosure, the diagnosis operation and/or the response operation of the first diagnosis module 200 and the second diagnosis module 300 may be performed individually on the battery. At this time, at least in a specific situation, the diagnosis operation or the response operation by the second diagnosis module 300 may have priority over the diagnosis operation or the response operation by the first diagnosis module 200.

In particular, as in the former embodiment, when it is determined whether to start an operation of the second diagnosis module 300 through the third diagnosis criterion, if the state information measured for the target battery deviates from the third diagnosis criterion, the second diagnosis module 300 may operate preferentially. At this time, the first diagnosis module 200 may temporarily or provisionally stop the diagnosis operation or the response operation while the operation of the second diagnosis module 300 is in progress. Also, after the diagnosis operation and/or the response operation by the second diagnosis module 300 is completed, the diagnosis operation and/or the response operation by the first diagnosis module 200 may be performed.

However, in a specific situation, after the diagnosis operation and/or the response operation by the second diagnosis module 300, the diagnosis operation and/or the response operation by the first diagnosis module 200 may not be performed. In particular, if the target battery is diagnosed as failure (Failure) by the second diagnosis module 300, charging and discharging may be blocked as a response operation. In this case, the first diagnosis module 200 may not perform a separate additional diagnosis operation (first diagnosis operation) or response operation. Meanwhile, if the target battery is diagnosed as normal by the second diagnosis module 300, the first diagnosis module 200 may perform the first diagnosis operation and a resultant response operation.

According to this embodiment of the present disclosure, more efficient diagnosis or response operations may be possible. In particular, if the battery is diagnosed as abnormal by the second diagnosis module 300, the abnormal level may be serious. Therefore, it is desirable to preferentially perform the diagnosis operation or the response operation by the second diagnosis module 300. Moreover, the first diagnosis module 200 and the second diagnosis module 300 may share power or resources of the memory 400 or the like. In this case, by giving priority to the second diagnosis module 300, the response operation by the second diagnosis module 300 may be performed first. In addition, the first diagnosis module 200 and the second diagnosis module 300 may be implemented by one component, such as a processor, and in this case, by giving priority to the second diagnosis module 300, the second diagnosis operation more appropriate for an urgent situation may be performed rapidly.

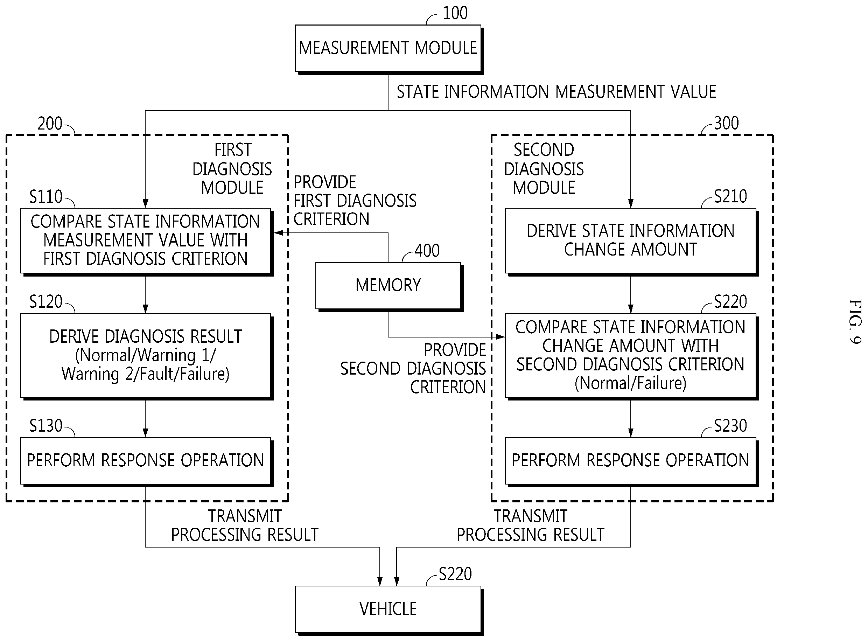

FIG. 9 is a flowchart for schematically illustrating the operation of the apparatus for managing a battery according to an embodiment of the present disclosure.

Referring to FIG. 9, if the measurement module 100 measures state information of the battery, the state information measurement value may be transmitted to the first diagnosis module 200 and the second diagnosis module 300, respectively.

At this time, the first diagnosis module 200 may perform a first diagnosis operation by comparing the state information measurement value with the first diagnosis criterion (S110) and deriving a diagnosis result (S120). At this time, the diagnosis result of the first diagnosis operation derived in the step S120 refers to whether the battery is abnormal or refers to an abnormal level, and may be derived in several stages such as Normal, Warning 1, Warning 2, Fault, and Failure. Also, the first diagnosis module 200 may perform the response processing operation according to the derived diagnosis stage (S130) and transmit the processing result to a vehicle or the like.

Also, in order to perform a second diagnosis operation, the second diagnosis module 300 may derive the state information change amount (ex. voltage change amount) through the state information measurement value transmitted from the measurement module 100 (S210). In particular, in the step S210, the second diagnosis module 300 may derive the state information change amount using the currently transmitted state information measurement value and the previously transmitted state information measurement value. Also, the second diagnosis module 300 may compare the derived state information change amount with the second diagnosis criterion (S220). In the step S220, the second diagnosis module 300 may diagnose the state of the battery as normal (Normal) or failure (Failure). In addition, the second diagnosis module 300 may perform a response processing operation according to the diagnosis result (S230) and transmit the processing result to a vehicle or the like. For example, in the step S230, the second diagnosis module 300 may block charging and discharging of the battery.

In addition, the memory 400 may store information necessary for the first diagnosis module 200 and the second diagnosis module 300 to perform operations, and transmit the stored information to the first diagnosis module 200 and the second diagnosis module 300. For example, the memory 400 may be configured to store data for the first diagnosis criterion and the second diagnosis criterion, and the first diagnosis module 200 and the second diagnosis module 300 may be configured to be capable of accessing the stored data.

In the embodiment of FIG. 9, at least some of the operations performed by the first diagnosis module 200 may be performed after the operations performed by the second diagnosis module 300. For example, in FIG. 9, the response operation performing step (S130) by the first diagnosis module 200 may be performed after the response operation performing step (S230) by the second diagnosis module 300. In this case, the steps S110 and S120 by the first diagnosis module 200 may be performed regardless of the diagnosis operation by the second diagnosis module 300.

As another example, in FIG. 9, all steps (steps S110 to S130) performed by the first diagnosis module 200 may be performed after the entire operations (steps S210 to S230) by the second diagnosis module 300 are performed. Moreover, the entire operations (steps S110 to S130) of the first diagnosis module 200 may be configured to be performed only when it is diagnosed as normal (Normal) by the second diagnosis module 300 in the step S220.

Meanwhile, in the embodiment of FIG. 9, the battery mounted on the vehicle is described, but the battery may also be mounted on other devices. In this case, the first diagnosis module 200 and/or the second diagnosis module 300 may transmit the processing result to another device or the like.

A battery pack according to the present disclosure may include the apparatus for managing a battery according to the present disclosure described above. The battery pack according to the present disclosure includes, in addition to the apparatus for managing a battery according to the present disclosure, components typically included in the battery pack, such as a battery cell, a pack housing, and electronic components such as a fuse, a relay and a BMS. Moreover, at least some functions, configurations, operations, etc. of the apparatus for managing a battery according to the present disclosure may be implemented by a BMS or various sensors included in the battery pack.

In addition, the battery pack according to the present disclosure may be a public exchangeable battery pack for a vehicle, especially an electric two-wheeled vehicle. Also, the apparatus for managing a battery according to the present disclosure may be mounted on such a public exchangeable battery pack for an electric two-wheeled vehicle.

In addition, a vehicle according to the present disclosure may include the apparatus for managing a battery according to the present disclosure or the battery pack according to the present disclosure. Moreover, the vehicle according to the present disclosure may be powered by electricity and may include a battery pack for driving. At this time, the apparatus for managing a battery according to the present disclosure may be provided entirely at the battery pack. Alternatively, the apparatus for managing a battery according to the present disclosure may be provided in a form in which some functions or configurations are shared between the battery pack and the vehicle. For example, most of the operations or functions of the first diagnosis module 200 or the second diagnosis module 300 are performed by the BMS of the battery pack, but some operations or functions may be implemented by a higher-level system at the vehicle, such as an ECU (Energy Control Unit) or VCU (Vehicle Control Unit).

Also, the vehicle according to the present disclosure may further include other components generally applied to the vehicle, in addition to the apparatus for managing a battery or battery pack. In particular, the vehicle according to the present disclosure may be an electric two-wheeled vehicle.

In addition, a battery providing system according to the present disclosure may include the apparatus for managing a battery according to the present disclosure. Here, the battery providing system may be a concept that includes a battery charging system that provides a charging service for a discharged battery, or a battery exchange system that provides a service for exchanging a discharged battery with a charged battery. Also, the battery providing system may include a battery inspection and repair system, such as a service center that repairs or inspects the battery. Also, the battery providing system may include a battery sales system that allows users to purchase batteries.

The present disclosure has been described in detail. However, it should be understood that the detailed description and specific examples, while indicating embodiments of the disclosure, are given by way of illustration only, since various changes and modifications within the scope of the disclosure will become apparent to those skilled in the art from this detailed description.

Reference Signs

100: measurement module
200: first diagnosis module
300: second diagnosis module
400: memory

**Claims**

1. An apparatus for managing a battery, the apparatus comprising:

   a measurement module configured to measure state information of the battery;
   a first diagnosis module configured to diagnose whether the battery is abnormal by comparing the state information measured by the measurement module with a first diagnosis criterion; and
   a second diagnosis module configured to diagnose whether the battery is abnormal based on a change amount of the state information measured by the measurement module.

2. The apparatus for managing the battery according to claim 1, wherein the state information includes a voltage value, and
   wherein the first diagnosis module and the second diagnosis module are configured to diagnose whether the battery has low voltage or overvoltage.

3. The apparatus for managing the battery according to claim 1, wherein the first diagnosis criterion is configured in multi-stage form, and
   wherein the first diagnosis module is configured to classify an abnormal state of the battery into a plurality of diagnosis stages.

4. The apparatus for managing the battery according to claim 1, wherein the first diagnosis module is configured to diagnose whether the battery is abnormal by considering a time duration of the state information measured by the measurement module together.

5. The apparatus for managing the battery according to claim 1, wherein the second diagnosis module is configured to enable abnormality diagnosis in a situation where abnormality is not diagnosed by the first diagnosis module.

6. The apparatus for managing the battery according to claim 1, wherein the measurement module measures the state information periodically, and wherein the second diagnosis module is configured to calculate the change amount of the state information by using currently measured state information and state information measured in a previous period.

7. The apparatus for managing the battery according to claim 1, wherein the second diagnosis module is configured to diagnose whether the battery is abnormal by comparing the change amount of the state information with a second diagnosis criterion.

8. The apparatus for managing the battery according to claim 7, wherein the second diagnosis module is configured to diagnose whether the battery is abnormal by comparing a number of times the change amount of the state information deviates from the second diagnosis criterion with a criterion number.

9. The apparatus for managing the battery according to claim 8, wherein the criterion number has different values depending on the change amount of the state information.

10. The apparatus for managing the battery according to claim 9, wherein the second diagnosis module is configured to diagnose whether the battery is abnormal by changing the criterion number, when the change amount of the state information changes.

11. The apparatus for managing the battery according to claim 1, wherein the second diagnosis module is configured to compare the state information measured by the measurement module with a third diagnosis criterion and operate when the measured state information deviates from the third diagnosis criterion.

12. The apparatus for managing the battery according to claim 1, wherein the second diagnosis module is configured to block a charging operation or a discharging operation of the battery when the battery is diagnosed as abnormal.

13. The apparatus for managing the battery according to claim 1, wherein the second diagnosis module is configured to perform an operation with priority over the first diagnosis module.

14. A battery pack, comprising the apparatus for managing the battery according to any one of claims 1 to 13.

15. A vehicle, comprising the apparatus for managing the battery according to any one of claims 1 to 13.

16. A battery providing system, comprising the apparatus for managing the battery according to any one of claims 1 to 13.

FIG. 1

APPARATUS FOR MANAGING BATTERY

100 — MEASUREMENT MODULE

300 — SECOND DIAGNOSIS MODULE

200 — FIRST DIAGNOSIS MODULE

400 — MEMORY

FIG. 2

| Level | FIRST DIAGNOSIS STAGE | |
|-------|----------------------|---|
| C1 | Normal | |
| C2 | Warning 1 | ← R1 |
| C3 | Warning 2 | ← R2 |
| C4 | Fault | ← R3 |
| C5 | Failure | ← R4 |

FIG. 3

| Level | First Diagnosis Stage | First Criterion Voltage | Criterion Time |
|-------|----------------------|------------------------|----------------|
| C1 | Normal | greater than 3.1V | – |
| C2 | Warning 1 | 3.1V or less | 1 second |
| C3 | Warning 2 | 2.5V or less | 1 second |
| C4 | Fault | 2.3V or less | 1 second |
| C5 | Failure | 2V or less | 20 seconds |

FIG. 4

FIG. 5

| Level | Second Diagnosis Stage | Criterion Change Amount | Criterion Number | Second Criterion Voltage |
|-------|------------------------|-------------------------|------------------|--------------------------|
| E1 | Normal | - | - | greater than 3.1V |
| E2 | Failure | greater than 0.03V | 10 cycle | 3.1V or less |

FIG. 6

FIG. 7

FIG. 8

| Level | Criterion Change Amount | Criterion Number |
|---|---|---|
| E21 | greater than 0.03V | 10 cycle |
| E22 | greater than 0.09V | 5 cycle |
| E23 | greater than 0.16V | 3 cycle |
| E24 | greater than 0.23V | 2 cycle |
| E25 | greater than 0.3V | 2 cycle |

FIG. 9

## INTERNATIONAL SEARCH REPORT

| International application No. |
|---|
| **PCT/KR2024/096979** |

| **A.** | **CLASSIFICATION OF SUBJECT MATTER** |
|---|---|

**G01R 31/382**(2019.01)i; **G01R 31/392**(2019.01)i; **G01R 31/396**(2019.01)i; **G01R 19/165**(2006.01)i; **B60L 58/10**(2019.01)i; **H01M 10/052**(2010.01)i

According to International Patent Classification (IPC) or to both national classification and IPC

| **B.** | **FIELDS SEARCHED** |
|---|---|

Minimum documentation searched (classification system followed by classification symbols)

G01R 31/382(2019.01); B60L 3/00(2006.01); B60L 58/16(2019.01); B60L 58/18(2019.01); B60R 16/04(2006.01); G01R 19/00(2006.01); G01R 31/367(2019.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 측정(measure), 기준(criteria), 비교(compare), 변화량(variance), 전압(voltage), 차단(cut off)

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| X | KR 10-2022-0093843 A (LG ENERGY SOLUTION, LTD.) 05 July 2022 (2022-07-05)<br>See paragraphs [0002]-[0101], claims 1, 2 and 12 and figures 2-5. | 1,2,5-7,13-16 |
| Y |  | 3,4,8-12 |
| Y | JP 2021-166442 A (TOYOTA MOTOR CORP. et al.) 14 October 2021 (2021-10-14)<br>See claims 1, 2, 5 and 7 and figures 1-4. | 3,4,8-10 |
| Y | KR 10-2023-0126467 A (HYUNDAI MOBIS CO., LTD.) 30 August 2023 (2023-08-30)<br>See claims 1-4 and figures 1-4. | 11,12 |
| A | KR 10-2021-0040721 A (LG CHEM, LTD.) 14 April 2021 (2021-04-14)<br>See claims 1-10 and figures 2-4. | 1-16 |
| A | KR 10-2555776 B1 (QUANTUM SOLUTION) 14 July 2023 (2023-07-14)<br>See paragraphs [0032]-[0073] and figures 1-3 and 6. | 1-16 |

☐ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **19 March 2025** | **19 March 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** |  |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/096979**

| Patent document cited in search report | | | Publication date (day/month/year) | Patent family member(s) | | | Publication date (day/month/year) |
|---|---|---|---|---|---|---|---|
| KR | 10-2022-0093843 | A | 05 July 2022 | CN | 116134325 | A | 16 May 2023 |
| | | | | EP | 4202457 | A1 | 28 June 2023 |
| | | | | JP | 2023-533238 | A | 02 August 2023 |
| | | | | JP | 7537824 | B2 | 21 August 2024 |
| | | | | US | 2023-0258735 | A1 | 17 August 2023 |
| | | | | WO | 2022-145998 | A1 | 07 July 2022 |
| JP | 2021-166442 | A | 14 October 2021 | CN | 113495219 | A | 12 October 2021 |
| | | | | CN | 113495219 | B | 06 September 2024 |
| | | | | DE | 102021108398 | A1 | 07 October 2021 |
| | | | | JP | 7311458 | B2 | 19 July 2023 |
| | | | | US | 11789085 | B2 | 17 October 2023 |
| | | | | US | 2021-0311124 | A1 | 07 October 2021 |
| KR | 10-2023-0126467 | A | 30 August 2023 | None | | | |
| KR | 10-2021-0040721 | A | 14 April 2021 | CN | 113874737 | A | 31 December 2021 |
| | | | | CN | 113874737 | B | 28 May 2024 |
| | | | | EP | 3926353 | A1 | 22 December 2021 |
| | | | | EP | 3926353 | B1 | 11 September 2024 |
| | | | | ES | 2991907 | T3 | 05 December 2024 |
| | | | | JP | 2022-516753 | A | 02 March 2022 |
| | | | | JP | 7127762 | B2 | 30 August 2022 |
| | | | | PL | 3926353 | T3 | 16 December 2024 |
| | | | | US | 11762023 | B2 | 19 September 2023 |
| | | | | US | 2022-0170988 | A1 | 02 June 2022 |
| | | | | WO | 2021-066555 | A1 | 08 April 2021 |
| KR | 10-2555776 | B1 | 14 July 2023 | KR | 10-2022-0057862 | A | 09 May 2022 |

Form PCT/ISA/210 (patent family annex) (July 2022)

**REFERENCES CITED IN THE DESCRIPTION**

**Patent documents cited in the description**

- KR 1020230191795